(19) Europäisches Patentamt
European Patent Office
Office européen des brevets

(11) **EP 4 546 229 A1**

(12) **EUROPEAN PATENT APPLICATION**
published in accordance with Art. 153(4) EPC

(43) Date of publication:
**30.04.2025 Bulletin 2025/18**

(21) Application number: **23825748.9**

(22) Date of filing: **13.01.2023**

(51) International Patent Classification (IPC):
***G06Q 10/06*** (2023.01)

(52) Cooperative Patent Classification (CPC):
Y02E 60/10

(86) International application number:
**PCT/CN2023/072160**

(87) International publication number:
**WO 2023/246088 (28.12.2023 Gazette 2023/52)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **24.06.2022 CN 202210725707**

(71) Applicant: **Huaneng Clean Energy Research
Institute
Beijing 102209 (CN)**

(72) Inventors:
  • **WANG, Ning**
    **Beijing 102209 (CN)**
  • **CAO, Xi**
    **Beijing 102209 (CN)**
  • **CAO, Chuanzhao**
    **Beijing 102209 (CN)**
  • **WEI, Yu**
    **Beijing 102209 (CN)**
  • **SONG, Jishuo**
    **Beijing 102209 (CN)**
  • **LEI, Haodong**
    **Beijing 102209 (CN)**
  • **SUN, Zhouting**
    **Beijing 102209 (CN)**
  • **YAN, Yunling**
    **Beijing 102209 (CN)**
  • **LIU, Mingyi**
    **Beijing 102209 (CN)**
  • **PEI, Jie**
    **Beijing 102209 (CN)**

(74) Representative: **advotec.
Patent- und Rechtsanwaltspartnerschaft
Tappe mbB
Widenmayerstraße 4
80538 München (DE)**

(54) **LITHIUM BATTERY PERFORMANCE SCORE CALCULATION METHOD AND SYSTEM**

(57)    Disclosed is a lithium battery performance score calculation method and system. The method comprises: acquiring data information during the operation of a lithium battery, and uploading the data to a lithium battery performance score database; using the lithium battery performance score database to construct a lithium battery performance scoring system from three dimensions: battery nameplate attributes, operation attributes and environment attributes; and constructing a battery performance score calculation model by using a fuzzy comprehensive evaluation method and calculating performance index scores of the lithium battery.

```
┌─────────────────────────────────────────────────────┐
│ acquiring data during operation of a lithium battery │──── Step 1
│ and uploading the data to a lithium battery          │
│ performance scoring database                         │
└─────────────────────────────────────────────────────┘
                          │
                          ▼
┌─────────────────────────────────────────────────────┐
│ constructing a lithium battery performance scoring   │──── Step 2
│ system based on the lithium battery performance      │
│ scoring database from three dimensions of battery    │
│ nameplate attributes, operational attributes, and    │
│ environmental attributes                             │
└─────────────────────────────────────────────────────┘
                          │
                          ▼
┌─────────────────────────────────────────────────────┐
│ constructing a battery performance scoring           │──── Step 3
│ calculation model based on a fuzzy comprehensive     │
│ evaluation method, and calculating scores of         │
│ respective performance metrics of the lithium battery│
└─────────────────────────────────────────────────────┘
```

FIG. 1

EP 4 546 229 A1

**Description**

**CROSS-REFERENCE TO RELATED APPLICATIONS**

This application is based on and claims priority to Chinese Patent Application with Application No. 2022107257073, filed on June 24, 2022 in China, the entire contents of which are incorporated herein by reference into this paper.

**TECHNICAL FIELD**

The present disclosure relates to a field of energy storage technologies, specifically to a lithium battery performance scoring calculation method and a system thereof.

**BACKGROUND**

With further development of energy storage industry, more and more new energy power generation such as wind energy and photovoltaics choose to store electrical energy. Lithium batteries are widely used in energy storage due to advantages of high energy density, stable electrochemical properties, less pollution, and long cycle life, etc. The lithium batteries also promote sustained and rapid economic development. However, as the number of charging and discharging cycles of energy storage increases, the lithium batteries may slowly undergo irreversible aging, which directly affects practicality, economy, and safety of the lithium batteries. Therefore, being able to accurately and quickly evaluate a real-time performance status of the lithium batteries not only improves safety of related fields, but also saves a lot of money and time in the energy storage field. Therefore, developing a method that can accurately evaluate the performance status of the lithium batteries is of great significance for its practical application.

A traditional lithium battery performance status evaluation method has great ambiguity, one-sided evaluation metrics, and human influence, and cannot accurately and comprehensively reflect the performance status of the lithium batteries, and an evaluation result is less convincing.

**SUMMARY**

The present disclosure provides a lithium battery performance scoring calculation method and a system thereof to at least solve the problem that a lithium battery performance status evaluation method in related arts has great ambiguity, one-sided evaluation metrics, and human influence, and cannot accurately and comprehensively reflect the performance status of the lithium batteries, and an evaluation result is less convincing.

According to a first aspect of embodiments of the present disclosure, a lithium battery performance scoring calculation method is provided. The method includes:

acquiring data during operation of a lithium battery and uploading the data to a lithium battery performance scoring database;

constructing a lithium battery performance scoring system based on the lithium battery performance scoring database from three dimensions of battery nameplate attributes, operational attributes, and environmental attributes;

constructing a battery performance scoring calculation model based on a fuzzy comprehensive evaluation method, and calculating scores of respective performance metrics of the lithium battery.

According to a second aspect of embodiments of the present disclosure, a lithium battery performance scoring calculation system is provided. The system includes:

an acquisition module, configured to acquire data during operation of a lithium battery and upload the data to a lithium battery performance scoring database;

a constructing module, configured to construct a lithium battery performance scoring system based on the lithium battery performance scoring database from three dimensions of battery nameplate attributes, operational attributes, and environmental attributes; and

a calculation module, configured to construct a battery performance scoring calculation model based on a fuzzy comprehensive evaluation method, and calculate scores of respective performance metrics of the lithium battery.

According to a third aspect of embodiments of the present disclosure, an electronic device is provided. The electronic device includes a memory, a processor and a computer program stored on the memory and executable by the processor, in which the processor is configured to implement the lithium battery performance scoring calculation method as described in the first aspect of the present disclosure when executing the computer program.

According to a fourth aspect of embodiments of the present disclosure, a non-transitory computer-readable storage medium with a computer program stored thereon is provided. The computer program is caused to implement the lithium battery performance scoring calculation method as described in the first aspect of the present disclosure when executed by a processor.

According to a fifth aspect of embodiments of the present disclosure, a computer program product is provided. The computer program product includes a computer program, which causes the lithium battery performance scoring calculation method as described in the first aspect of embodiments of the present disclosure to be implemented when executed by a processor.

According to another aspect of embodiments of the present aspect, a computer program including computer program codes is provided. A computer is caused to implement the lithium battery performance scoring calculation method as described in the first aspect of embodiments of the present disclosure when the computer program codes are running on the computer.

The technical solutions provided by embodiments of the present disclosure at least may have following beneficial effects.

The present disclosure provides the lithium battery performance scoring calculation method and the system thereof, the method includes acquiring the data during operation of a lithium battery and uploading the data to the lithium battery performance scoring database, constructing the lithium battery performance scoring system based on the lithium battery performance scoring database from the three dimensions of battery nameplate attributes, operational attributes, and environmental attributes, constructing the battery performance scoring calculation model based on the fuzzy comprehensive evaluation method, and calculating the scores of respective performance metrics of the lithium battery. Thus, the present disclosure may achieve real-time, fast, and accurate calculation of performance of the lithium battery, and evaluate a performance status of the lithium battery, improve a maintenance and repair efficiency of the lithium battery, and ensure safe and stable operation of the lithium battery.

Additional aspects and advantages of the present disclosure will be set forth in part in the following description, and in part will become obvious from the following description, or may be learned by practice of the disclosure.

## BRIEF DESCRIPTION OF THE DRAWINGS

The above and/or additional aspects and advantages of the present disclosure will become obvious and easy to understand from the following description of the embodiments in conjunction with the accompanying drawings, in which:

FIG. 1 is a flowchart illustrating a lithium battery performance scoring calculation method according to an embodiment of the present disclosure;

FIG. 2 is a flowchart illustrating a specific lithium battery performance scoring calculation method according to an embodiment of the present disclosure;

FIG. 3 is a schematic diagram illustrating a fuzzy comprehensive evaluation model in a lithium battery performance scoring calculation method according to an embodiment of the present disclosure;

FIG. 4 is a visual interface diagram for lithium battery performance status analysis in a lithium battery performance scoring calculation method according to an embodiment of the present disclosure;

FIG. 5 is a block diagram illustrating a lithium battery performance scoring calculation system according to an embodiment of the present disclosure.

## DETAILED DESCRIPTION

Embodiments of the present disclosure are described in detail below, and examples of embodiments are illustrated in the accompanying drawings, in which the same or similar labels represent the same or similar elements or elements with the same or similar functions. The embodiments described below with reference to the drawings are exemplary, are intended to be configured to explain the present disclosure and are not to be construed as a limitation of the present disclosure.

The present disclosure provides a lithium battery performance scoring calculation method and a system thereof, the method includes acquiring data during operation of a lithium battery and uploading the data to a lithium battery performance scoring database, constructing a lithium battery performance scoring system based on the lithium battery performance scoring database from three dimensions of battery nameplate attributes, operational attributes, and environmental attributes, constructing a battery performance scoring calculation model based on a fuzzy comprehensive evaluation method, and calculating scores of respective performance metrics of the lithium battery. Thus, the present disclosure may achieve real-time, fast, and accurate calculation of performance of the lithium battery, and evaluate a performance status of the lithium battery, improve a maintenance and repair efficiency of the lithium battery, and ensure safe and stable operation of the lithium battery.

A lithium battery performance scoring calculation method and a system thereof according to embodiments of the present disclosure are described below with reference to the accompany drawings.

Embodiment 1

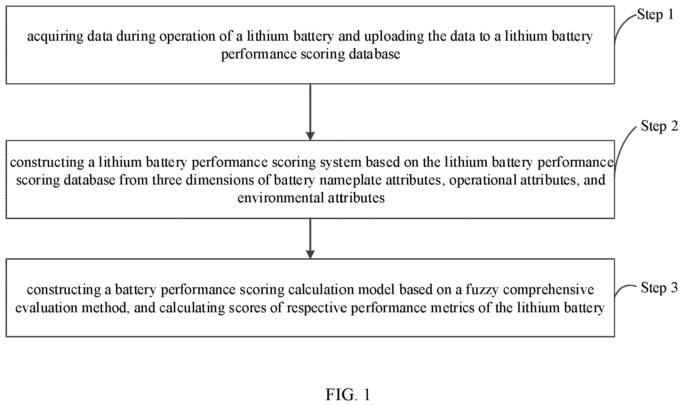

FIG. 1 is a flowchart illustrating a lithium battery performance scoring calculation method according to an embodiment of the present disclosure. As illustrated in FIG. 1, the method may include following steps 1 to 3.

At step 1, data during operation of a lithium battery is acquired and the data is uploaded to a lithium battery performance scoring database.

The data during operation of the lithium battery includes power, voltage, current, temperature, etc., during operation of the lithium battery.

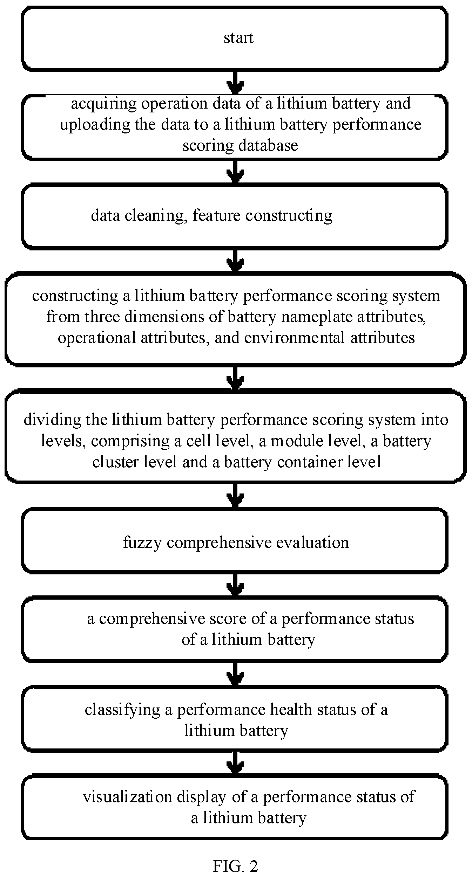

FIG. 2 is a flowchart illustrating a specific lithium battery performance scoring calculation method according to an embodiment of the present disclosure. As illustrated in FIG. 2, after uploading the data to the lithium battery performance scoring database, the method further includes: performing cleaning processing on lithium battery performance data in the lithium battery performance scoring database.

Performing the cleaning processing on the lithium battery performance data in the lithium battery performance scoring database includes: filling in missing values and processing exception values.

Filling in missing values refers to removing data of the day if the missing values exceeds 5 points, and filling in the missing values using an average of three pieces of data before and after if the missing values below 5 points. Processing exception values refers to, for exception values, constructing an identification method for exception values of metrics using statistics analysis, box line diagram method, etc., and deleting or filling exception values as required.

At step 2, a lithium battery performance scoring system is constructed based on the lithium battery performance scoring database from three dimensions of battery nameplate attributes, operational attributes, and environmental attributes.

**In** an embodiment of the present disclosure, before constructing the lithium battery performance scoring system based on the lithium battery performance scoring database from three dimensions of battery nameplate attributes, operational attributes, and environmental attributes, the method further includes: constructing lithium battery metrics features related to lithium battery performance.

Methods of constructing the lithium battery metrics features related to lithium battery performance include: descriptive statistics, correlation analysis, data transformation, data coding, binning, and feature combination.

Furthermore, the nameplate attributes include a battery model number, a battery capacity, a battery manufacturing date, a batch, a manufacturer and a location.

The operational attributes include a total operational power, a total voltage, a total current, maximum and minimum voltages, and maximum and minimum temperatures;

The environmental attributes include maximum and minimum external temperatures, maximum and minimum humidifies, and weather data.

At step 3, a battery performance scoring calculation model is constructed based on a fuzzy comprehensive evaluation method, and scores of respective performance metrics of the lithium battery are calculated.

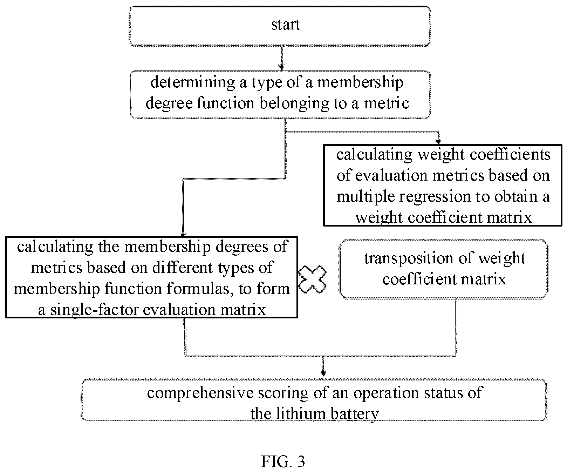

FIG. 3 is a schematic diagram illustrating a fuzzy comprehensive evaluation model in a lithium battery performance scoring calculation method according to an embodiment of the present disclosure. The constructing the battery performance scoring calculation model based on the fuzzy comprehensive evaluation method specifically includes:

F1: the lithium battery performance scoring system is divided into levels, including a cell level, a module level, a battery cluster level and a battery container level.

It should be noted that traditional lithium battery performance evaluation is only for cell-level performance evaluation. As a huge power system, an energy storage power station has integrated operation of a large number of cells. Therefore, the method of in the present disclosure not only performs performance evaluation for cell-level, but also performs stepped evaluation for the upper module level, the battery cluster level and the battery container level, allowing for a comprehensive evaluation of the overall performance of the energy storage power station.

F2: respective metric features of the lithium battery at different levels are divided into corresponding to different types of membership functions.

It should be noted that respective individual metrics of the lithium battery may be divided into different types of membership functions. The membership functions include "parabolic", "positive S-line" and "linear".

F3: a membership degree is calculated by incorporating each individual metric feature of the lithium battery into a membership function corresponding to the individual metric feature of the lithium battery, and an evaluation matrix A of individual factors at respective levels of the lithium battery is obtained by combining membership degrees.

Further, a formula of the parabolic membership function is provided as:

$$u1(x) = \begin{cases} 1.0 & x_2 \leq x \leq x_3 \\ 0.9 \times \dfrac{x - x_1}{x_2 - x_1} + 0.1 & x_1 \leq x \leq x_2 \\ 0.9 \times \dfrac{x_4 - x}{x_4 - x_3} + 0.1 & x_3 \leq x \leq x_4 \\ 0.1 & x \leq x_1, x \geq x_4 \end{cases}$$

where u1(x) is a value of the parabolic membership function, $x_1$ denotes a numerical lower limit, $x_2$ denotes an optimal numerical lower limit, $x_3$ denotes an optimal numerical upper limit, and $x_4$ denotes a numerical upper limit;
a formula of the positive S-line membership function is provided as:

$$u2(x) = \begin{cases} 1.0 & x_4 \leq x \\ 0.9 \times \dfrac{x - x_1}{x_4 - x_1} & x_1 \leq x \leq x_4 \\ 0.1 & x \leq x_1 \end{cases}$$

where u2(x) is a value of the positive S-line membership function, $x_1$ represents a numerical lower limit, and $x_4$ denotes a numerical upper limit;
(3) a formula of the linear membership function is provided as:

$$u3(x) = k * x + b$$

where u3(x) is a value of the linear membership function, where,

$$k = \frac{1 - 0.1}{x_4 - x_1}, \quad b = 1 - k * x_4$$

where $x_4$ denotes a numerical upper limit, and $x_1$ represents a numerical lower limit.

Specifically, the membership degree is calculated by incorporating a measured value of the metric into the formula of the corresponding membership function according to the membership function and a predefined metric critical value. That is, the value of the parabolic membership function, the value of the positive S-line membership function and the value of the linear membership function form the evaluation matrix A of individual factors provided as:

$$A = \begin{bmatrix} \mu_{11} & \mu_{12} & \cdots & \mu_{1n} \\ \mu_{21} & \mu_{22} & \cdots & \mu_{2n} \\ \vdots & \vdots & \ddots & \vdots \\ \mu_{m1} & \mu_{m2} & \cdots & \mu_{mn} \end{bmatrix}$$

where A is a matrix of m rows and n columns, m is a number of samples of the lithium battery, n is a number of matrixes of the lithium battery; $\mu_{11}$ is a membership degree of a first feature of a first battery sample; $\mu_{1n}$ is a membership degree of an n-th feature of the first battery sample; $\mu_{mn}$ is a membership degree of an n-th feature of an m-th battery sample.
F4: weight coefficients of the respective metric features of the lithium battery are calculated using a multiple linear regression method, and a weight coefficient matrix R is constructed by combining weight coefficients that affect performance of the lithium battery
F5: a comprehensive evaluation index is calculated by multiplying the evaluation matrix of individual factors and a transposed weight coefficient matrix using a fuzzy comprehensive evaluation method, and a battery performance scoring calculation model is built, and scores of respective performance metrics of the lithium battery are obtained by calculation. With obtaining a comprehensive scoring result of different levels of respective performance metric statuses of the lithium battery, accurate evaluation of the performance status of the lithium battery is achieved.
The calculating the weight coefficients of the respective metric features of the lithium battery using the multiple linear regression method, and constructing the weight coefficient matrix R by combining the weight coefficients that affect performance of the lithium battery, and calculating the comprehensive evaluation index by multiplying the evaluation matrix of individual factors and the transposed weight coefficient matrix using the fuzzy comprehensive evaluation method, building the battery performance scoring calculation model specifically includes followings.

H1: a linear regression equation between a k-th metric of the lithium battery and other metrics is established, in which a formula of $\hat{x}_k$ is provided as:

$$\hat{x}_k = \hat{\beta}_0 + \hat{\beta}_1 x_1 + \hat{\beta}_2 x_2 + \cdots + \hat{\beta}_k x_k + \hat{\beta}_{k+1} x_{k+1} + \cdots + \hat{\beta}_n x_n$$

where $\hat{\beta}$ is a constant term, n is a number of metrics of the lithium battery, $x_1$, $x_2$......$x_n$ are other metrics among the metrics of the lithium battery except $\hat{x}_k$.

H2: complex correlation coefficients of metrics are calculated,

in which a formula of a complex correlation coefficient $Z_k$ of a k-th metric is provided as:

$$Z_k = \frac{\sum(x_k - \bar{x}_k)(\hat{x}_k - \bar{x}_k)}{\sqrt{\sum(x_k - \bar{x}_k)^2 \sum(\hat{x}_k - \bar{x}_k)^2}}$$

where $\bar{x}_k$ is an average value of $x_k$.

H3: a metric weight coefficient matrix is constructed.

in which weight coefficients r of respective metrics are obtained by normalizing a reciprocal ($1/Z_k$) of the complex correlation coefficient of each metric to forming the weight coefficient matrix R provided as:

$$R = \begin{bmatrix} r_1 & r_2 & \cdots & r_n \end{bmatrix},$$

where, $r_1$ is a weight coefficient of a first lithium battery metric, $r_n$ is a weight coefficient of an n-th lithium battery metric.

H4: the comprehensive evaluation index B is synthetized and calculated using a fuzzy matrix; in which a formula of the comprehensive evaluation index B is provided as:

$$B = A \times R^T = \begin{bmatrix} \mu_{11} & \mu_{12} & \cdots & \mu_{1n} \\ \mu_{21} & \mu_{22} & \cdots & \mu_{2n} \\ \vdots & \vdots & \ddots & \vdots \\ \mu_{m1} & \mu_{m2} & \cdots & \mu_{mn} \end{bmatrix} \times \begin{bmatrix} r_1 \\ r_2 \\ \vdots \\ r_n \end{bmatrix} = \begin{bmatrix} y_1 \\ y_2 \\ \vdots \\ y_m \end{bmatrix}$$

where $y_1$ is a comprehensive score of a performance status of a first lithium battery sample, $y_m$ is a comprehensive score of an m-th lithium battery sample, and m is a number of lithium battery samples.

It should be noted that due to influence of human factors in weight acquisition methods such as an analytic hierarchy process, the method calculates the weight coefficients of metrics of the lithium battery using the multiple linear regression method, the principle of which is to determine the weight coefficients of metrics based on a strength of collinearity between each metric of the lithium battery and other metrics, without influence of human factors.

The method calculates the weight coefficients of metrics of the lithium battery using the multiple linear regression method, and determines the weight of metrics based on the strength of the collinearity between each metric of the lithium battery and other metrics. That is, the greater the complex correlation coefficient Z between a certain metric and other metrics, the stronger the collinear relationship between the metric and other metrics, the easier the metric is to be represented by a linear combination of other indicators. The more repeated information, the smaller the weight of the metric should be.

In an embodiment of the present disclosure, the lithium battery performance scoring calculation method further includes:

classifying, according to an evaluation result, a performance health status of the lithium battery into four levels, including healthy (excellent), sub-health (good), unhealthy (less poor), and seriously unhealthy (poor);

plotting a visual interface for performance status of the lithium battery.

The visual interface includes number of lithium battery devices, distribution topology, temperature, and a performance status result, which is configured to provide lithium battery non-health warnings for a transportation and inspection department.

Specifically, Table 1 shows a health status corresponding to an evaluation score, as illustrated in Table 1.

| Comprehensive score range | Performance status storing of lithium battery |
| --- | --- |
| Score>80 points | healthy |
| 60<Score<80 | sub-healthy |
| 20<Score<60 | un healthy |
| Score>25 | Seriously unhealthy |

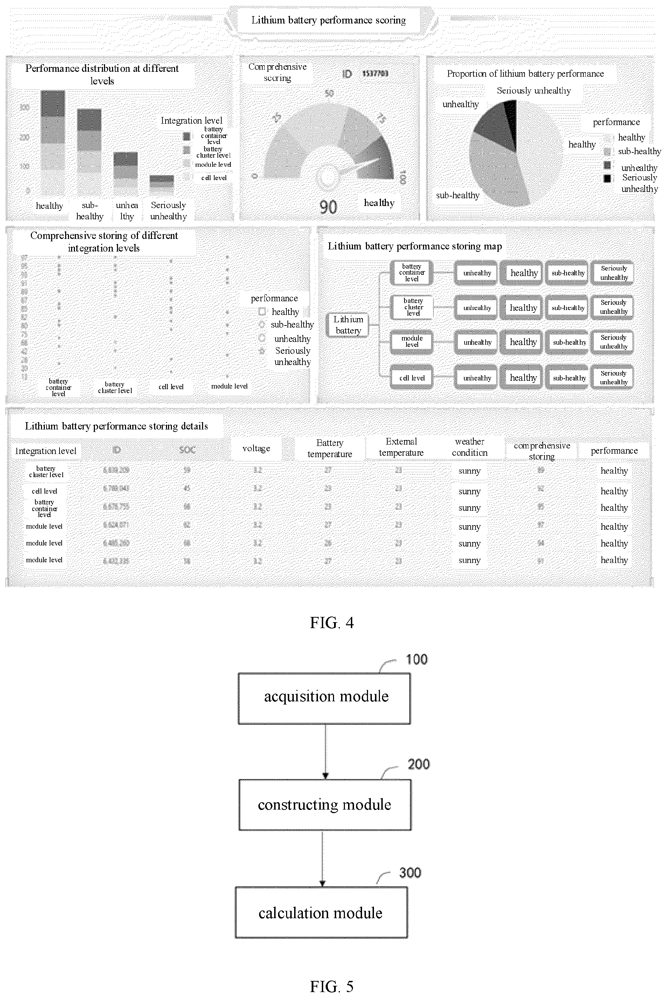

FIG. 4 is a visual interface diagram for lithium battery performance status analysis in a lithium battery performance scoring calculation method according to an embodiment of the present disclosure. As illustrated in FIG. 4, the lithium battery performance status comprehensive scoring is accessed to the visual interface for intuitive display of the performance status of the lithium battery. The content includes but is not limited to the number, distribution, temperatures, and health status results of the lithium battery devices, etc., which provides the transportation inspection department with lithium battery non-health warnings.

It should be noted that for lithium batteries that are in an unhealthy state, it further focuses on dimensions such as operating years, load capacity ratio, and number of heavy overloads, and performs score analysis from these dimensions. A dimension with a lower score is included in the scope of equipment maintenance to assist fault location and improve inspection efficiency.

The score analysis is performed based on the comprehensive evaluation result, and the dimension with a low score is included in the scope of equipment maintenance to assist in fault location and improve inspection efficiency. Big data technology is used to carry out real-time monitoring and early warning of lithium battery performance status, enabling comprehensive interaction between relevant staff and equipment to achieve holographic perception of lithium battery status.

To sum up, embodiments of the present disclosure provide a lithium battery performance scoring calculation method. The method includes acquiring the data during operation of a lithium battery and uploading the data to the lithium battery performance scoring database, constructing the lithium battery performance scoring system based on the lithium battery performance scoring database from the three dimensions of battery nameplate attributes, operational attributes, and environmental attributes, constructing the battery performance scoring calculation model based on the fuzzy comprehensive evaluation method, and calculating the scores of respective performance metrics of the lithium battery. Thus, the present disclosure may achieve real-time, fast, and accurate calculation of performance of the lithium battery, and evaluate a performance status of the lithium battery, improve a maintenance and repair efficiency of the lithium battery, and ensure safe and stable operation of the lithium battery. The present disclosure may achieve accurate assessment of the performance status of lithium batteries, and develop visual scenarios of lithium battery performance status, and intuitively display the real-time operation status of the lithium battery in an energy storage unit. The present disclosure may be applied to support formulation of lithium battery maintenance plan strategies and guide proactive repairs.

Embodiment 2

FIG. 5 is a block diagram illustrating a lithium battery performance scoring calculation system according to an embodiment of the present disclosure. As illustrated in FIG. 5, the system includes:

an acquisition module 100, configured to acquire data during operation of a lithium battery and upload the data to a lithium battery performance scoring database;

a constructing module 200, configured to construct a lithium battery performance scoring system based on the lithium battery performance scoring database from three dimensions of battery nameplate attributes, operational attributes, and environmental attributes;

a calculation module 300 construct a battery performance scoring calculation model based on a fuzzy comprehensive evaluation method, and calculate scores of respective performance metrics of the lithium battery.

The system also includes a cleaning unit, configured to perform cleaning processing on lithium battery performance data uploaded into the lithium battery performance scoring database, specifically including filling in missing values or processing exception values, etc.

In summary, according to the lithium battery performance scoring calculation system provided by embodiments of the present disclosure, real-time, fast, and accurate calculation and evaluation of the performance status of the lithium battery are achieved.

Embodiment 3

In order to implement the above embodiment, this embodiment also provides an electronic device.

The electronic device provided in an embodiment includes a memory, a processor, and a computer program stored on the memory and executable by the processor. the processor is configured to implement the lithium battery performance scoring calculation method according to Embodiment 1 is implemented when executing the computer program.

Embodiment 4

In order to implement the above embodiment, this embodiment also provides a non-transitory computer-readable storage medium.

The non-transitory computer-readable storage medium provided in this embodiment has a computer program stored thereon. When the computer program is executed by the processor, the lithium battery performance scoring calculation method as described in Embodiment 1 is implemented.

Embodiment 5

In order to implement the above embodiment, this embodiment also provides a computer program product.

The computer program product provided by this embodiment includes a computer program, in which the computer program causes the lithium battery performance scoring calculation method as described in Embodiment 1 to be implemented when executed by a processor.

Embodiment 6

In order to implement the above embodiment, this embodiment also provides a computer program.

This embodiment provides the computer program, and the computer program includes computer program codes. A computer is caused to implement the lithium battery performance scoring calculation method as described in Embodiment 1 when the computer program codes are running on the computer.

It should be noted that the foregoing explanation and description of the embodiments of the lithium battery performance scoring calculation method also applies to the lithium battery performance scoring calculation system, the electronic device, the non-transitory computer-readable storage media, and the computer program product and the computer program as described in Embodiments 2-6 of the present disclosure, which will not be described in detail here.

In descriptions of the specification, descriptions with reference to terms "one embodiment", "some embodiments", "examples", "specific examples" or "some examples" etc. mean specific features, structures, materials or characteristics described in conjunction with the embodiment or example are included in at least one embodiment or example of the present disclosure. In this specification, the schematic representations of the above terms do not have to be the same embodiment or example. Moreover, specific features, structures, materials or characteristics described may be combined in any one or more embodiments or examples in a suitable manner. In addition, those skilled in the art may combine different embodiments or examples and characteristics of different embodiments or examples described in this specification without contradicting each other.

Any process or method descriptions described in the flowchart or in other ways herein may be understood as a module, a segment or a part of a code including one or more executable instructions configured to implement steps of customized logical functions or processes, and scopes of embodiments of the present disclosure include additional implementations, which may include implement functions not be in the order shown or discussed including the substantially simultaneous manner according to functions involved or in reverse order, which should be understood by those skilled in the art of embodiments of the present disclosure.

**Claims**

1. A lithium battery performance scoring calculation method, comprising:

   acquiring data during operation of a lithium battery and uploading the data to a lithium battery performance scoring database;

constructing a lithium battery performance scoring system based on the lithium battery performance scoring database from three dimensions of battery nameplate attributes, operational attributes, and environmental attributes;

constructing a battery performance scoring calculation model based on a fuzzy comprehensive evaluation method, and calculating scores of respective performance metrics of the lithium battery.

2. The method according to claim 1, wherein after uploading the data to the lithium battery performance scoring database, the method further comprises: performing cleaning processing on lithium battery performance data in the lithium battery performance scoring database;

wherein performing the cleaning processing on the lithium battery performance data in the lithium battery performance scoring database comprises: filling in missing values or processing exception values.

3. The method according to claim 1 or 2, wherein before constructing the lithium battery performance scoring system based on the lithium battery performance scoring database from three dimensions of battery nameplate attributes, operational attributes, and environmental attributes, the method further comprises:

constructing lithium battery metrics features related to lithium battery performance;

wherein, methods of constructing the lithium battery metrics features related to lithium battery performance comprise: descriptive statistics, correlation analysis, data transformation, data coding, binning, and feature combination;

the nameplate attributes comprise a battery model number, a battery capacity, a battery manufacturing date, a batch, a manufacturer and a location;

the operational attributes comprise a total operational power, a total voltage, a total current, maximum and minimum voltages, and maximum and minimum temperatures;

the environmental attributes comprise maximum and minimum external temperatures, maximum and minimum humidities, and weather data.

4. The method according to any one of claims 1 to 3, wherein constructing the battery performance scoring calculation model based on the fuzzy comprehensive evaluation method, and calculating the scores of respective performance metrics of the lithium battery comprises:

dividing the lithium battery performance scoring system into levels, comprising a cell level, a module level, a battery cluster level and a battery container level;

dividing respective metric features of the lithium battery at different levels into corresponding to different types of membership functions;

calculating a membership degree by incorporating each individual metric feature of the lithium battery into a membership function corresponding to the individual metric feature of the lithium battery, and obtaining an evaluation matrix A of individual factors at respective levels of the lithium battery by combining membership degrees;

calculating weight coefficients of the respective metric features of the lithium battery using a multiple linear regression method, and constructing a weight coefficient matrix R by combining weight coefficients that affect performance of the lithium battery;

calculating a comprehensive evaluation index by multiplying the evaluation matrix of individual factors and a transposed weight coefficient matrix using a fuzzy comprehensive evaluation method, building a battery performance scoring calculation model, and calculating scoring results of different levels of performance metrics of the lithium battery;

wherein types of the membership function comprise: a parabolic membership function, a positive S-line membership function and a linear membership function.

5. The method according to claim 4, wherein a formula of the parabolic membership function is provided as:

$$u1(x) = \begin{cases} 1.0 & x_2 \leq x \leq x_3 \\ 0.9 \times \dfrac{x - x_1}{x_2 - x_1} + 0.1 & x_1 \leq x \leq x_2 \\ 0.9 \times \dfrac{x_4 - x}{x_4 - x_3} + 0.1 & x_3 \leq x \leq x_4 \\ 0.1 & x \leq x_1, x \geq x_4 \end{cases}$$

where u1(x) is a value of the parabolic membership function, $x_1$ denotes a numerical lower limit, $x_2$ denotes an optimal numerical lower limit, $x_3$ denotes an optimal numerical upper limit, and $x_4$ denotes a numerical upper limit; a formula of the positive S-line membership function is provided as:

$$u2(x) = \begin{cases} 1.0 & x_4 \leq x \\ 0.9 \times \dfrac{x - x_1}{x_4 - x_1} & x_1 \leq x \leq x_4 \\ 0.1 & x \leq x_1 \end{cases}$$

where u2(x) is a value of the positive S-line membership function, $x_1$ represents a numerical lower limit, and $x_4$ denotes a numerical upper limit; a formula of the linear membership function is provided as:

$$u3(x) = k * x + b$$

where u3(x) is a value of the linear membership function, where,

$$k = \frac{1-0.1}{x_4 - x_1}, \quad b = 1 - k * x_4$$

where $x_4$ denotes a numerical upper limit, and $x_1$ represents a numerical lower limit; the value of the parabolic membership function, the value of the positive S-line membership function and the value of the linear membership function form the evaluation matrix A of individual factors provided as:

$$A = \begin{bmatrix} \mu_{11} & \mu_{12} & \cdots & \mu_{1n} \\ \mu_{21} & \mu_{22} & \cdots & \mu_{2n} \\ \vdots & \vdots & \ddots & \vdots \\ \mu_{m1} & \mu_{m2} & \cdots & \mu_{mn} \end{bmatrix}$$

wherein A is a matrix of m rows and n columns, m is a number of samples of the lithium battery, n is a number of matrixes of the lithium battery; $\mu_{11}$ is a membership degree of a first feature of a first battery sample; $\mu_{1n}$ is a membership degree of an n-th feature of the first battery sample; $\mu_{mn}$ is a membership degree of an n-th feature of an m-th battery sample.

6. The method according to claim 4, wherein calculating the weight coefficients of the respective metric features of the lithium battery using the multiple linear regression method, and constructing the weight coefficient matrix R by combining the weight coefficients that affect performance of the lithium battery, and calculating the comprehensive evaluation index by multiplying the evaluation matrix of individual factors and the transposed weight coefficient matrix using the fuzzy comprehensive evaluation method, building the battery performance scoring calculation model comprises:

H1: establishing a linear regression equation between a k-th metric of the lithium battery and other metrics, wherein a formula of $\hat{x}_k$ is provided as:

$$\hat{x}_k = \hat{\beta}_0 + \hat{\beta}_1 x_1 + \hat{\beta}_2 x_2 + \cdots + \hat{\beta}_k x_k + \hat{\beta}_{k+1} x_{k+1} + \cdots + \hat{\beta}_n x_n$$

where $\hat{\beta}$ is a constant term, n is a number of metrics of the lithium battery, $x_1, x_2 \ldots \ldots x_n$ are other metrics among the metrics of the lithium battery except $\hat{x}_k$;

H2: calculating complex correlation coefficients of metrics;

wherein a formula of a complex correlation coefficient $Z_k$ of a k-th metric is provided as:

$$Z_k = \frac{\sum (x_k - \bar{x}_k)(\hat{x}_k - \bar{x}_k)}{\sqrt{\sum (x_k - \bar{x}_k)^2 \sum (\hat{x}_k - \bar{x}_k)^2}}$$

where $\bar{x}_k$ is an average value of $x_k$;

H3: constructing a metric weight coefficient matrix;

wherein weight coefficients r of respective metrics are obtained by normalizing a reciprocal ($1/Z_k$) of the complex correlation coefficient of each metric to forming the weight coefficient matrix R provided as:

$$R = \begin{bmatrix} r_1 & r_2 & \cdots & r_n \end{bmatrix}$$

where, $r_1$ is a weight coefficient of a first lithium battery metric, $r_n$ is a weight coefficient of an n-th lithium battery metric;

H4: synthetizing and calculating the comprehensive evaluation index B using a fuzzy matrix; wherein a formula of the comprehensive evaluation index B is provided as:

$$B = A \times R^T = \begin{bmatrix} \mu_{11} & \mu_{12} & \cdots & \mu_{1n} \\ \mu_{21} & \mu_{22} & \cdots & \mu_{2n} \\ \vdots & \vdots & \ddots & \vdots \\ \mu_{m1} & \mu_{m2} & \cdots & \mu_{mn} \end{bmatrix} \times \begin{bmatrix} r_1 \\ r_2 \\ \vdots \\ r_n \end{bmatrix} = \begin{bmatrix} y_1 \\ y_2 \\ \vdots \\ y_m \end{bmatrix}$$

where $y_1$ is a comprehensive score of a performance status of a first lithium battery sample, $y_m$ is a comprehensive score of an m-th lithium battery sample, and m is a number of lithium battery samples.

7. The method according to any one of claims 1 to 6, further comprising:

classifying, according to an evaluation result, a performance health status of the lithium battery into four levels, comprising healthy, sub-healthy, unhealthy and seriously unhealthy;

plotting a visual interface for performance status of the lithium battery;

wherein the visual interface comprises number of lithium battery devices, distribution topology, temperature, and a performance status result, which is configured to provide lithium battery non-health warnings for a transportation and inspection department.

8. A lithium battery performance scoring calculation system, comprising:

an acquisition module, configured to acquire data during operation of a lithium battery and upload the data to a lithium battery performance scoring database;

a constructing module, configured to construct a lithium battery performance scoring system based on the lithium battery performance scoring database from three dimensions of battery nameplate attributes, operational attributes, and environmental attributes; and

a calculation module, configured to construct a battery performance scoring calculation model based on a fuzzy comprehensive evaluation method, and calculate scores of respective performance metrics of the lithium battery.

9. An electronic device, comprising a memory, a processor and a computer program stored on the memory and executable by the processor, wherein the processor is configured to implement the lithium battery performance scoring calculation method according to any one of claims 1 to 7 when executing the computer program.

10. A computer-readable storage medium with a computer program stored thereon, wherein the computer program is caused to implement the lithium battery performance scoring calculation method according to any one of claims 1 to 7 when executed by a processor.

11. A computer program product, comprising a computer program, which causes the lithium battery performance scoring calculation method according to any one of claims 1 to 7 to be implemented when executed by a processor.

12. A computer program comprising computer program codes, causing a computer to implement the lithium battery performance scoring calculation method according to any one of claims 1 to 7 when the computer program codes are running on the computer.

acquiring data during operation of a lithium battery and uploading the data to a lithium battery performance scoring database

Step 1

constructing a lithium battery performance scoring system based on the lithium battery performance scoring database from three dimensions of battery nameplate attributes, operational attributes, and environmental attributes

Step 2

constructing a battery performance scoring calculation model based on a fuzzy comprehensive evaluation method, and calculating scores of respective performance metrics of the lithium battery

Step 3

FIG. 1

start

acquiring operation data of a lithium battery and uploading the data to a lithium battery performance scoring database

data cleaning, feature constructing

constructing a lithium battery performance scoring system from three dimensions of battery nameplate attributes, operational attributes, and environmental attributes

dividing the lithium battery performance scoring system into levels, comprising a cell level, a module level, a battery cluster level and a battery container level

fuzzy comprehensive evaluation

a comprehensive score of a performance status of a lithium battery

classifying a performance health status of a lithium battery

visualization display of a performance status of a lithium battery

FIG. 2

```
                    ┌─────────────────────────────┐
                    │            start            │
                    └─────────────────────────────┘
                                   │
                    ┌─────────────────────────────┐
                    │ determining a type of a     │
                    │ membership degree function  │
                    │ belonging to a metric       │
                    └─────────────────────────────┘
```

start

determining a type of a membership degree function belonging to a metric

calculating weight coefficients of evaluation metrics based on multiple regression to obtain a weight coefficient matrix

calculating the membership degrees of metrics based on different types of membership function formulas, to form a single-factor evaluation matrix

transposition of weight coefficient matrix

comprehensive scoring of an operation status of the lithium battery

FIG. 3

FIG. 4

FIG. 5

## INTERNATIONAL SEARCH REPORT

| International application No. |
| --- |
| **PCT/CN2023/072160** |

**A. CLASSIFICATION OF SUBJECT MATTER**

G06Q 10/06(2023.01)i

According to International Patent Classification (IPC) or to both national classification and IPC

**B. FIELDS SEARCHED**

Minimum documentation searched (classification system followed by classification symbols)

G06Q

Documentation searched other than minimum documentation to the extent that such documents are included in the fields searched

Electronic data base consulted during the international search (name of data base and, where practicable, search terms used)

DWPI, CNTXT, ENTXT, ENTXTC, CNKI, IEEE: 锂电池, 电池, 性能, 状态, 评分, 评价, 数据, 属性, 指标, 特征, 模型, 铭牌, 运行, 环境, 隶属度函数, 隶属度, 函数, 权重, 可视化, 评价矩阵 Lithium Battery, Battery, Performance, Status, Score, Assessment, Data, Attributes, Indicators, Features, Model, Nameplate, Running, Environment, membership function, membership, Function, Weights, Visualization, Assessment Matrix

**C. DOCUMENTS CONSIDERED TO BE RELEVANT**

| Category* | Citation of document, with indication, where appropriate, of the relevant passages | Relevant to claim No. |
| --- | --- | --- |
| PX | CN 115187013 A (CHINA HUANENG CLEAN ENERGY RESEARCH INSTITUTE) 14 October 2022 (2022-10-14)<br>description, paragraphs [0004]-[0103], and figures 1-5 | 1-12 |
| Y | CN 109604186 A (BEIJING ARTICORE BATTERY TECHNOLOGY CO., LTD.) 12 April 2019 (2019-04-12)<br>claims 1-8, and description, figure 1 | 1-12 |
| Y | CN 109061516 A (HARBIN UNIVERSITY OF SCIENCE AND TECHNOLOGY) 21 December 2018 (2018-12-21)<br>claims 1-8, and description, figures 1-3 | 1-12 |
| A | CN 110008235 A (UBIAI TECHNOLOGY LTD.) 12 July 2019 (2019-07-12)<br>entire document | 1-12 |
| A | US 7072871 B1 (CADEX ELECTRONICS INC.) 04 July 2006 (2006-07-04)<br>entire document | 1-12 |

☑ Further documents are listed in the continuation of Box C.    ☑ See patent family annex.

| * Special categories of cited documents: | |
| --- | --- |
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **24 February 2023** | **07 March 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

# EP 4 546 229 A1

**INTERNATIONAL SEARCH REPORT**

International application No.

**PCT/CN2023/072160**

## C. DOCUMENTS CONSIDERED TO BE RELEVANT

| Category* | Citation of document, with indication, where appropriate, of the relevant passages | Relevant to claim No. |
|---|---|---|
| A | US 2011054815 A1 (XU JIANHONG; ZHENG YI;) 03 March 2011 (2011-03-03) entire document | 1-12 |

Form PCT/ISA/210 (second sheet) (July 2022)

INTERNATIONAL SEARCH REPORT
Information on patent family members

International application No.

**PCT/CN2023/072160**

| Patent document cited in search report | | | Publication date (day/month/year) | Patent family member(s) | | | Publication date (day/month/year) |
|---|---|---|---|---|---|---|---|
| CN | 115187013 | A | 14 October 2022 | None | | | |
| CN | 109604186 | A | 12 April 2019 | CN | 109604186 | B | 07 December 2021 |
| CN | 109061516 | A | 21 December 2018 | None | | | |
| CN | 110008235 | A | 12 July 2019 | None | | | |
| US | 7072871 | B1 | 04 July 2006 | None | | | |
| US | 2011054815 | A1 | 03 March 2011 | US | 8306781 | B2 | 06 November 2012 |
| | | | | WO | 2008128426 | A1 | 30 October 2008 |
| | | | | JP | 2010519691 | A | 03 June 2010 |
| | | | | JP | 5203394 | B2 | 05 June 2013 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 2022107257073